# DEMANDE DE BREVET EUROPEEN

(11) **EP 4 434 795 A1**
(43) Date de publication de la demande: **25.09.2024**
(21) Numéro de dépôt: 24159251.8
(22) Date de dépôt: 22.02.2024
(51) Int. Cl.: B60L 3/00, G01R 31/52, H02H 3/16, H02J 7/00, G01R 27/18, G01R 27/16

(54) **COMPOSANT ÉLECTRONIQUE DESTINÉ À ÊTRE EMBARQUÉ SUR UN VÉHICULE**

(30) Priorité: 24.03.2023 FR 2302839
(71) Demandeur: Valeo eAutomotive Germany GmbH, 91056 Erlangen (DE)
(72) Inventeur: FIORINA, Jean-Noel, 95892 Cergy Pontoise (FR); JACQUES, Fred, 95892 Cergy Pontoise (FR)
(74) Mandataire: Valeo Powertrain Systems

(57) **Abrégé**

Composant électronique (2) pour la charge d'une unité de stockage d'énergie électrique (4), comprenant :
- un connecteur (5) apte à être branché à un réseau électrique fournissant une tension alternative,
- un onduleur/redresseur (6), et
- un convertisseur continu/continu (8), l'onduleur/redresseur (6) étant disposé en série entre le connecteur (5) et le convertisseur continu/continu (8),
le composant (2) comprenant un dispositif de détection (1) d'un défaut d'isolement entre la terre et l'un au moins du neutre et d'une phase de la tension alternative, ce dispositif comprenant :
une entrée (12, 13) connectée au neutre ou à une phase de la tension alternative,
une sortie (15) connectée à la terre,
une impédance (16) disposée entre l'entrée (12, 13) et la sortie (15),
une détection d'un défaut d'isolement étant effectuée en fonction de la valeur d'une grandeur électrique associée à cette résistance électrique.

## Description

La présente invention concerne un composant électronique destiné à être embarqué sur un véhicule. Un tel composant assure par exemple l'alimentation électrique d'une unité de stockage d'énergie électrique de véhicule, et il est encore appelé « chargeur » de cette d'unité de stockage d'énergie électrique. L'unité de stockage d'énergie électrique est par exemple une batterie, pouvant présenter une tension nominale supérieure à 60V, par exemple supérieure ou égale à 300V, à 400V, à 800V, voire à 1000V Ce composant comprend dans un exemple connu :
- un onduleur/redresseur recevant en entrée une tension alternative et fournissant en sortie une tension continue, et
- un convertisseur DC/DC disposé en aval de l'onduleur/redresseur et connecté à l'unité de stockage d'énergie électrique.

Il existe un besoin pour améliorer encore de tels composants.

La demande EP 3 879 285 enseigne de détecter un défaut d'isolement entre le neutre et la terre et entre une phase d'une tension alternative et la terre en exploitant les tensions existant respectivement aux bornes de condensateurs de filtrage CEM disposés respectivement entre le neutre et la terre et la phase et la terre.

L'invention a pour but de répondre à ce besoin et elle y parvient, selon l'un de ses aspects, à l'aide d'un composant électronique pour la charge d'une unité de stockage d'énergie électrique, comprenant :
- un connecteur apte à être branché à un réseau électrique fournissant une tension alternative,
- un onduleur/redresseur, et
- notamment un convertisseur DC/DC, l'onduleur/redresseur étant disposé en série entre le connecteur et le convertisseur DC/DC,
le composant comprenant un dispositif de détection d'un défaut d'isolement entre la terre et l'un au moins du neutre et d'une phase de la tension alternative, ce dispositif comprenant :
- une entrée connectée au neutre ou à une phase de la tension alternative,
- une sortie connectée à la terre,
- une impédance, notamment une résistance de mesure, disposée entre l'entrée et la sortie, une détection d'un défaut d'isolement étant effectuée en fonction de la valeur d'une grandeur électrique associée à cette impédance.

La présence d'un tel dispositif de détection de défaut d'isolement permet un fonctionnement du composant électronique en mode inverse, une charge ou le réseau électrique étant alors alimenté depuis l'unité de stockage d'énergie électrique. La détection de défaut d'isolement garantit la sécurité d'utilisateurs au contact de la charge ou du réseau électrique. La charge peut être quelconque, englobant notamment l'unité de stockage d'énergie d'un autre véhicule selon une configuration dite V2V (« vehicle to vehicle » en anglais) ou tout équipement d'une habitation ou d'un local.

Au sein du composant, le neutre et la terre sont de préférence isolés. Lorsque le composant est embarqué sur un véhicule, son châssis est par exemple à la terre et la distance d'isolement et les lignes de fuite par rapport au châssis peuvent alors être conformes à la norme IEC 60664-4. Le cas échéant, la ou les phases de la tension alternative sont également isolées par rapport à la terre. La distance d'isolement et les lignes de fuites de cette ou ces phases par rapport au châssis est par exemple conforme à la norme IEC 60664-4.

Le dispositif de détection d'un défaut d'isolement comprend par exemple un système de détermination déterminant la valeur de la grandeur électrique associée à l'impédance, par exemple la tension aux bornes de cette impédance ou le courant circulant dans cette impédance. Cette détermination se fait par exemple par une mesure.

Le dispositif de détection d'un défaut d'isolement peut comprendre un interrupteur commandable, configuré pour interrompre la circulation de courant entre l'entrée et l'impédance. Ainsi, cet interrupteur permet lorsqu'il est ouvert qu'il n'y ait pas de perte de courant à travers le dispositif de détection de défaut d'isolement. On permet ainsi de réduire les pertes électriques causées par l'ajout de cette fonction de détection d'un défaut d'isolement puisque le dispositif de détection n'est pas électriquement connecté en permanence au reste du circuit, notamment lorsque l'onduleur/redresseur fonctionne en redresseur.

Cet interrupteur commandable est par exemple un relais électrotechnique L'invention n'est cependant pas limitée à un tel exemple, d'autres interrupteurs étant possibles, par exemple un relais statique à base de coupleurs optiques et/ou de transistor MOS et/ou de transistor IGBT.

La grandeur électrique associée à l'impédance est par exemple la tension aux bornes de l'impédance. En variante, cette grandeur électrique est par exemple le courant qui circule dans cette l'impédance.

L'impédance est par exemple disposée par rapport à l'entrée et la sortie du dispositif de détection d'un défaut d'isolement de manière à ce que la tension aux bornes de l'impédance s'obtienne de la tension entre l'entrée et la sortie du dispositif de détection d'un défaut d'isolement par pont diviseur de tension.

Le composant peut comprendre une unité de traitement configurée pour déduire de la valeur de tension déterminée aux bornes de l'impédance l'une au moins de :
- la valeur de l'impédance entre le neutre et la terre et,
- la valeur de l'impédance entre la phase et la terre.

Cette unité de traitement peut appartenir au dispositif de détection d'un défaut d'isolement, par exemple au système de détermination, ou être une unité de traitement distincte de ce dispositif. Cette unité de traitement est par exemple intégrée à la commande de l'onduleur/redresseur. Dans une variante, cette une unité de traitement est par exemple intégrée à un module de commande de la transmission (appelé « TCU » en anglais, ou à un module de commande du véhicule (appelé « VCU » en anglais).

Lorsque la valeur d'impédance ainsi déduite est inférieure à une valeur seuil, un défaut d'isolement peut être détecté et générer des alarmes. La valeur seuil est par exemple 500'Ω/V, comme prescrit par la norme GBT 184874 -20XX.

Dans un exemple de réalisation, le dispositif de détection d'un défaut d'isolement comprend une première entrée connectée au neutre de la tension alternative, et une deuxième entrée connectée à une phase de la tension alternative.

Toujours selon cet exemple de réalisation, le dispositif de détection d'un défaut d'isolement peut définir une première branche entre la première entrée et un noeud, et une deuxième branche entre la deuxième entrée et le noeud, la première branche comprenant un premier interrupteur commandable, notamment un premier relais électrotechnique, et la deuxième branche comprenant un deuxième interrupteur commandable, notamment un deuxième relais électrotechnique.

Un tel dispositif de détection d'un défaut d'isolement permet, en cas de détection d'un tel défaut, d'indiquer si ce défaut existe entre la terre et le neutre ou entre la terre et l'une des phases de la tension alternative grâce à la présence des deux interrupteurs commandables.

Les premier et deuxième interrupteurs peuvent être commandés de manière à ce qu'ils puissent être dans les trois configurations suivantes :
- une configuration (i) dans laquelle le premier et deuxième interrupteur sont ouverts,
- une configuration (ii) dans laquelle le premier interrupteur est fermé, et le deuxième interrupteur est ouvert, et
- une configuration (iii) dans laquelle le premier interrupteur est ouvert, et le deuxième interrupteur est fermé.

La configuration (i) est notamment adaptée lorsque l'onduleur/redresseur fonctionne en redresseur, une tension alternative étant reçue depuis le réseau et utilisée pour charger l'unité de stockage d'énergie électrique du véhicule. La première configuration n'est par exemple effective que lorsque l'onduleur/redresseur fonctionne en redresseur.

Cependant la configuration (i) peut également être utile lorsque l'onduleur/redresseur fonctionne en onduleur, une tension alternative étant générée à partir de la tension continue aux bornes de l'unité de stockage d'énergie et fournie au connecteur. En effet, la détection de défaut d'isolement n'implique pas nécessairement, dans ce mode inverse, que l'un des premier et deuxième interrupteur soit toujours ouvert en alternance.

La configuration (ii) permet la circulation d'un courant à travers l'impédance entre le neutre de la tension alternative et la terre. Dans un tel cas, si un défaut d'isolement entre une phase et la terre existe, une résistance de défaut existe alors entre cette phase et la terre. La tension phase-neutre pour cette phase est alors appliquée à l'impédance et à cette résistance de défaut. Par application de pont diviseur de tension, on peut ainsi déduire la valeur de la tension aux bornes de l'impédance. En l'absence de défaut d'isolement entre phase et terre, la tension aux bornes de l'impédance est nulle, et cette tension aux bornes de l'impédance devient égale à la tension phase-neutre si le défaut d'isolement est tel que la résistance de défaut équivaut à un court-circuit.

La configuration (iii) permet la circulation d'un courant à travers l'impédance entre une phase de la tension alternative et la terre. Dans un tel cas, si un défaut d'isolement entre le neutre et la terre existe, une résistance de défaut existe alors entre le neutre et la terre. La tension phase-neutre pour la phase à laquelle est reliée la deuxième entrée du dispositif de détection d'un défaut d'isolement est alors appliquée à l'impédance et à cette résistance de défaut. Par application de pont diviseur de tension, on peut ainsi déduire la valeur de la tension aux bornes de l'impédance. En l'absence de défaut d'isolement entre neutre et terre, la tension aux bornes de l'impédance est nulle, et cette tension devient égale à la tension phase-neutre si le défaut d'isolement est tel que la résistance de défaut équivaut à un court-circuit.

L'unité de traitement peut être configurée pour:
- déduire de la valeur de tension déterminée aux bornes de l'impédance un défaut d'isolement entre le neutre et la terre dans la configuration dans laquelle le premier interrupteur est ouvert et le deuxième interrupteur est fermé et,
- déduire de la valeur de la tension déterminée aux bornes de l'impédance un défaut d'isolement entre la phase et la terre dans la configuration dans laquelle le premier interrupteur est fermé, et le deuxième interrupteur est ouvert.

La durée pendant laquelle le premier interrupteur est fermé et le deuxième interrupteur est ouvert peut être égale à la durée pendant laquelle le premier interrupteur est ouvert et le deuxième interrupteur est fermé. Cette égalité des durées permet de simplifier la commande des interrupteurs. Chaque durée est par exemple de l'ordre d'une minute.

En variante, les durées ci-dessus ne sont pas égales.

Dans le mode de réalisation précité dans lequel le dispositif de détection d'un défaut d'isolement définit une première branche entre la première entrée et un noeud, et une deuxième branche entre la deuxième entrée et le noeud, la première branche comprenant un premier interrupteur commandable, notamment un premier relais électrotechnique, et la deuxième branche comprenant un deuxième interrupteur commandable, notamment un deuxième relais électrotechnique, une autre résistance peut être montée en série entre le noeud et l'impédance à laquelle est associée la grandeur électrique utilisée par le système de détermination . Lorsque l'impédance est une résistance de mesure et lorsque la grandeur électrique est une tension, la présence de cette autre résistance peut permettre de rendre la valeur de la tension aux bornes de cette résistance de mesure compatible avec les composants du système de détermination.

La valeur de tension déterminée aux bornes de la résistance de mesure peut être comparée à une valeur prédéfinie correspondant à une absence d'un tel défaut d'isolement. Cette valeur prédéfinie est par exemple la valeur efficace de la somme des tensions phase-neutre de chaque phase multipliée chacune par un facteur qui est par exemple égal au rapport entre la valeur de la résistance de mesure et la valeur de l'autre résistance.

Dans tout ce qui précède, le composant peut comprendre un étage de filtrage du courant alternatif, cet étage de filtrage étant disposé en série entre le connecteur et l'onduleur/redresseur. Cet étage de filtrage permet par exemple, lorsque la tension alternative est polyphasée, un filtrage du courant de mode commun et/ou un filtrage du courant différentiel.

Dans ce cas, la ou les entrées du dispositif de détection d'un défaut d'isolement peuvent être disposées en série entre l'étage de filtrage et l'onduleur/redresseur. En variante, la ou les entrées du dispositif de détection d'un défaut d'isolement peuvent être disposées en série entre l'étage de filtrage et le connecteur.

Dans tout ce qui précède, la tension du réseau peut être polyphasée, notamment triphasée. Cette tension peut présenter une fréquence de 50 Hz ou 60 Hz et une valeur efficace de 230V ou 240V En variante, la tension du réseau peut être monophasée.

Dans tout ce qui précède, l'unité de stockage d'énergie électrique est par exemple une batterie, pouvant présenter une tension nominale supérieure à 60V, par exemple supérieure ou égale à 300V, à 400V, à 800V, voire à 1000V

Dans tout ce qui précède, l'impédance à laquelle le système de détermination est associé peut être une résistance. D'autres réalisations sont possibles, comme une inductance ou un condensateur.

Dans tout ce qui précède, l'onduleur/redresseur et le dispositif de détection d'un défaut d'isolement entre la terre et l'un au moins du neutre et d'une phase de la tension alternative peuvent être contenus dans un même boîtier du composant. L'onduleur/redresseur et le dispositif de détection d'un défaut d'isolement sont par exemple en permanence physiquement solidaires l'un de l'autre au sein du composant, contrairement au cas où le dispositif de détection d'un défaut d'isolement serait logé dans un interconnecteur entre le composant et le réseau électrique, cet interconnecteur n'étant alors électriquement connecté au composant que lorsque le composant échange de l'énergie électrique avec le réseau électrique. Le dispositif de détection d'un défaut d'isolement est par exemple porté en tout ou partie par une des cartes du composant, par exemple par la carte de puissance de l'onduleur/redresseur du composant et/ou par la carte de commande de cet onduleur/redresseur.

Le composant électronique peut comprendre, dans un même boîtier ou non, un onduleur/redresseur et un convertisseur DC/DC. Le convertisseur DC/DC présente par exemple une isolation galvanique, notamment via un transformateur tel qu'un transformateur triphasé.

L'invention a encore pour objet, selon un autre de ses aspects, un procédé de détection d'un défaut d'isolement entre la terre et l'un au moins du neutre et d'une phase de la tension alternative circulant dans un composant électronique comprenant :
- un connecteur branché à un réseau électrique ou à une charge,
- un onduleur/redresseur, et
- notamment un convertisseur DC/DC, l'onduleur/redresseur étant disposé en série entre le connecteur et le convertisseur DC/DC,
procédé dans lequel on utilise un dispositif de détection d'un défaut d'isolement comprenant :
- une entrée connectée au neutre ou à une phase de la tension alternative,
- une sortie connectée à la terre,
- une impédance, étant notamment une résistance de mesure, disposée entre l'entrée et la sortie, une détection d'un défaut d'isolement étant effectuée en fonction de la valeur d'une grandeur électrique associée à cette impédance.

Tout ou partie de ce qui a été mentionné ci-dessus s'applique encore à cet autre aspect de l'invention.

Le dispositif de détection d'un défaut d'isolement comprend par exemple une première entrée connectée au neutre de la tension alternative, et une deuxième entrée connectée à une phase de la tension alternative, une première branche étant définie entre la première entrée et un noeud, et cette première branche comprenant un premier interrupteur commandable, une deuxième branche étant définie entre la deuxième entrée et le noeud, et cette deuxième branche comprenant un deuxième interrupteur commandable,
procédé dans lequel :
- on commande les interrupteurs de manière à ce que le premier interrupteur soit fermé et à ce que le deuxième interrupteur soit ouvert pour détecter si un défaut d'isolement existe entre une phase et la terre, et
- on commande les interrupteurs de manière à ce que le premier interrupteur soit ouvert et à ce que le deuxième interrupteur soit fermé pour détecter si un défaut d'isolement existe entre le neutre et la terre.

Selon ce procédé, lorsque la puissance est transférée de l'unité de stockage d'énergie électrique vers le connecteur, la séquence de commande suivante des interrupteurs peut être répétée :
- commande des interrupteurs de manière à ce que le premier interrupteur soit fermé et à ce que le deuxième interrupteur soit ouvert pendant une première durée, puis
- commande des interrupteurs de manière à ce que le premier interrupteur soit ouvert et à ce que le deuxième interrupteur soit fermé pendant une deuxième durée.

Ainsi, ces commandes correspondant à l'alternance des configurations (ii) et (iii) précitées permettent de mettre en place une surveillance continue de la survenance d'un défaut d'isolement entre une phase et la terre ou entre le neutre et la terre. Cette séquence de commande est par exemple répétée tant qu'aucun défaut d'isolement n'est détecté et tant que de la puissance est transférée de l'unité de stockage d'énergie électrique vers le connecteur.

Selon la séquence de commande précitée, la première durée peut, ou non, être égale à la deuxième durée.

En variante, la séquence de commande des interrupteurs inclut, en plus de l'alternance des configurations (ii) et (iii) précitées, également la configuration (i) précitée dans laquelle le premier et deuxième interrupteur sont ouverts, cette configuration (i) étant par exemple présente entre chaque passage entre la configuration (ii) à (iii) et vice-versa.

Selon le procédé ci-dessus, l'onduleur/redresseur peut être commandé en onduleur, de manière à ce que le réseau électrique ou la charge soit alimenté en tension alternative depuis le composant.

L'invention pourra être mieux comprise à la lecture de la description qui va suivre d'exemples non limitatifs de mise en oeuvre de celle-ci :
- [Fig.1] représente un composant électronique assurant l'alimentation électrique d'une unité de stockage d'énergie électrique de véhicule,
- [Fig.2] représente une partie du composant électronique de la figure 1, comprenant également un dispositif de détection d'un défaut d'isolement selon un exemple de mise en oeuvre de l'invention,

- [Fig.3] est une modélisation du composant de la figure 2 en cas de défaut d'isolement entre une phase de la tension alternative et la terre,
- [Fig.4] est une modélisation du composant de la figure 2 en cas de défaut d'isolement entre le neutre de la tension alternative et la terre,
- [Fig.5] est une vue de la figure 2 sur laquelle un exemple de réalisation du système de détermination du dispositif de détection d'un défaut d'isolement est représenté, et
- [Fig.6] représente différentes étapes d'un procédé selon un exemple de mise en oeuvre de l'invention.

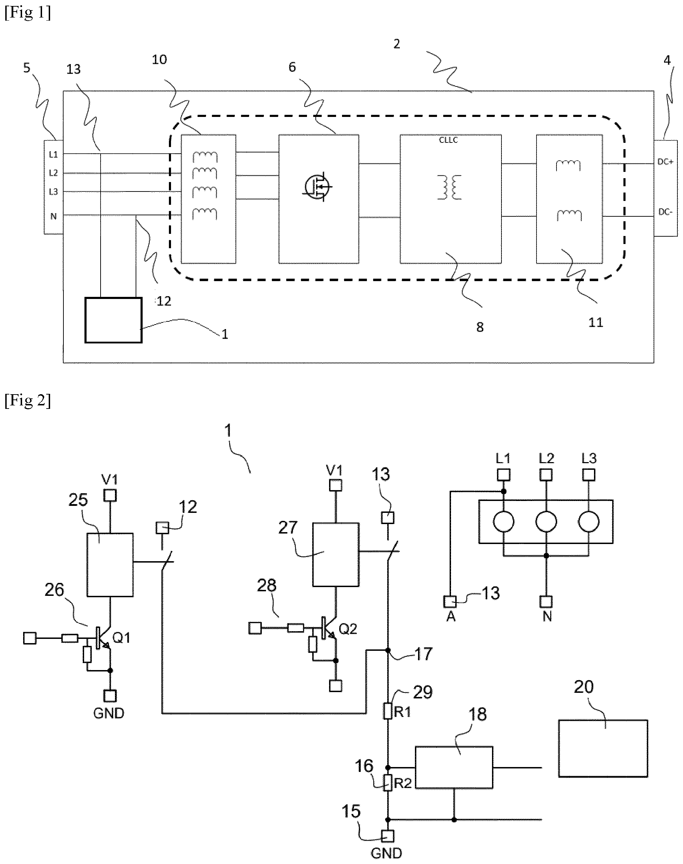

On a représenté sur la figure 1 un composant électronique 2 pour la charge d'une unité de stockage d'énergie électrique 4. Ce composant électronique 2 comprend :
- un connecteur 5 apte à être branché à un réseau électrique fournissant une tension alternative,
- un onduleur/redresseur 6, et
- un convertisseur DC/DC 8.

Comme on peut le voir sur la figure 1, l'onduleur/redresseur 6 est ici disposé en série entre le connecteur 5 et le convertisseur DC/DC 8.

L'unité de stockage d'énergie électrique 4 est ici une batterie utilisée pour l'alimentation électrique d'une machine électrique de propulsion de véhicule. Cette batterie présente par exemple une tension nominale supérieure à 60V, notamment à 300V, notamment à 400V, notamment à 800V, voire à 1000V

Le réseau électrique est par exemple un réseau triphasé véhiculant une tension dont la fréquence est de 50Hz ou 60Hz et dont la valeur efficace est de 230V ou 240V

Comme représenté sur la figure 1, un étage de filtrage 10 du courant alternatif peut être prévu, cet étage de filtrage 10 étant ici disposé en série entre le connecteur 5 et l'onduleur/redresseur 6. Cet étage de filtrage 10 permet par exemple, lorsque la tension alternative est polyphasée, un filtrage du courant de mode commun et/ou un filtrage du courant différentiel.

Le cas échéant, de manière facultative, un autre étage de filtrage 11 du courant continu peut être présent, étant alors disposé en série entre le convertisseur continu/continu 8 et l'unité de stockage d'énergie électrique 4, comme représenté sur la figure 1.

Le convertisseur continu/continu 8 est par exemple un convertisseur résonant, par exemple de type CLLC.

Selon l'invention, le composant 2 comprend un dispositif de détection d'un défaut d'isolement 1 entre l'un au moins :
- d'une phase de la tension alternative et la terre, et
- du neutre de la tension alternative et la terre.

Selon l'exemple représenté à la figure 2, le dispositif de détection de défaut d'isolement 1 présente deux entrées 12 et 13 qui peuvent être connectées à la tension alternative entre l'étage de filtrage 10 et l'onduleur/redresseur 6 ou qui peuvent être connectées à la tension alternative entre le connecteur 5 et l'étage de filtrage 10. Dans l'exemple de la figure 1, la connexion du dispositif de détection de défaut d'isolement s'effectue entre le connecteur 5 et l'étage de filtrage 10.

La présence dans l'exemple décrit de deux entrées 12 et 13 pour le dispositif de détection 1 permet de détecter un défaut d'isolement entre la terre et le neutre N, et un défaut d'isolement entre une phase L1, L2, L3 de la tension alternative et la terre. Plus précisément, l'entrée 12 définit une première entrée connectée au neutre N de la tension alternative, et l'entrée 13 définit une deuxième entrée connectée à une phase L1 par exemple de la tension alternative. Ce dispositif de détection 1 comprend encore une sortie 15 connectée à la terre, une impédance 16 qui est dans l'exemple considéré une résistance de mesure 16, et ici un système de détermination 18 de la tension aux bornes de cette résistance de mesure 16.

Le composant électronique 2 comprend encore une unité de traitement 20 mettant en oeuvre un ou plusieurs microcontrôleurs. Cette unité de traitement 20 peut être intégrée au dispositif de détection 1 et dédiée à ce dernier. Le cas échéant, cette unité de traitement est confondue avec le système de détermination 18. En variante, l'unité de traitement 20 appartient à une commande centralisée du véhicule, encore appelée « VCU », ou encore à une commande de l'onduleur/redresseur 6.

On constate sur la figure 2 que le dispositif 1 comprend, en plus des éléments précités :
- un premier interrupteur électronique 25, qui est ici un relais, et son circuit de commande 26, et
- un deuxième interrupteur électronique 27, qui est également un relais, et son circuit de commande 28.

Toujours sur la figure 2, on constate :
- qu'une première branche du dispositif 1 est définie entre la première entrée 12 et un noeud 17, cette première branche étant sélectivement ouverte ou fermée selon l'état du relais 25, et
- qu'une deuxième branche du dispositif 1 est définie entre la deuxième entrée 13 et le noeud 17, cette deuxième branche étant sélectivement ouverte ou fermée selon l'état du relais 27.

On constate également qu'une résistance 29 est montée en série entre le noeud 17 et la résistance de mesure 16, cette résistance 29 définissant avec la résistance de mesure 16 un montage de type pont diviseur de tension.

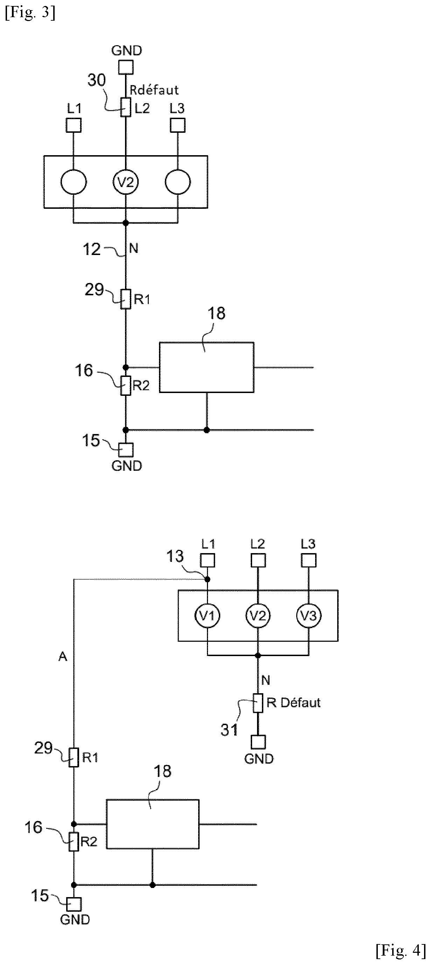

Le fonctionnement du dispositif de détection 1 d'un défaut d'isolement décrit en référence à la figure 2 va maintenant être expliqué en référence aux figures 3 et 4 qui modélisent respectivement le cas d'un défaut d'isolement entre la phase L2 et la terre et le cas d'un défaut d'isolement entre le neutre N et la terre.

Les relais 25 et 27 peuvent être commandés de manière à ce qu'ils puissent occuper les trois configurations suivantes :
- une configuration (i) dans laquelle ils sont tous deux ouverts, aucun courant ne circulant alors vers le dispositif de détection 1 de défaut d'isolement,
- une configuration (ii) dans laquelle le relais 25 est fermé, et le relais 27 est ouvert, et
- une configuration (iii) dans laquelle le relais 25 est ouvert, et le relais 27 est fermé.

La figure 3 correspond au cas où un défaut d'isolement existe entre la phase L2 et la terre. Lorsque le relais 25 est fermé, et le relais 27 ouvert, du courant circule via l'entrée 12 à travers les résistances 29 et 16 alors qu'une résistance de défaut 30 modélise le défaut d'isolement entre la phase L2 et la terre.

Par application de la loi des mailles, on constate que la tension phase-neutre V2 pour la phase L2 est alors appliquée aux résistances 16, 29 et 30. Le système de détermination 18 reçoit alors en entrée la tension appliquée aux bornes de la résistance de mesure 16.

En absence de défaut d'isolement, la valeur de la tension appliquée aux résistances 29 et 30 est nulle.

La valeur de la tension déterminée par le système de détermination 18 est ensuite utilisée pour détecter s'il existe ou non un défaut d'isolement entre l'une des phases du réseau et la terre. Cette détection peut être effectuée par le système de détermination 18 ou par l'unité de traitement 20, et elle peut consister à comparer la valeur déterminée aux bornes de la résistance de mesure 16 à une valeur prédéfinie correspondant à une absence d'un tel défaut d'isolement. Cette valeur prédéfinie est par exemple la valeur efficace de la somme des tensions phase-neutre de chaque phase multipliée chacune par un facteur, par exemple égal à 0,0125. Cette valeur prédéfinie est par exemple de l'ordre de 3V, par exemple égale à 2,994V.

La figure 4 correspond au cas où un défaut d'isolement existe entre le neutre N et la terre. Lorsque le relais 27 est fermé, et le relais 25 ouvert, du courant circule via l'entrée 13 à travers les résistances 29 et 16 alors qu'une résistance de défaut 31 modélise le défaut d'isolement entre le neutre N et la terre.

Par application de la loi des mailles, on constate que la tension phase-neutre V1 pour la phase L1 est alors appliquée aux résistances 16, 29 et 31. Le système de détermination 18 reçoit alors en entrée la tension appliquée aux bornes de la résistance de mesure 16.

En absence de défaut d'isolement, la valeur de la tension appliquée aux résistances 29 et 30 serait nulle.

Similairement à ce qui a été décrit en référence à la figure 3, la valeur de la tension déterminée par le système de détermination 18 est ensuite utilisée pour détecter s'il existe ou non un défaut d'isolement entre l'une des phases du réseau et la terre.

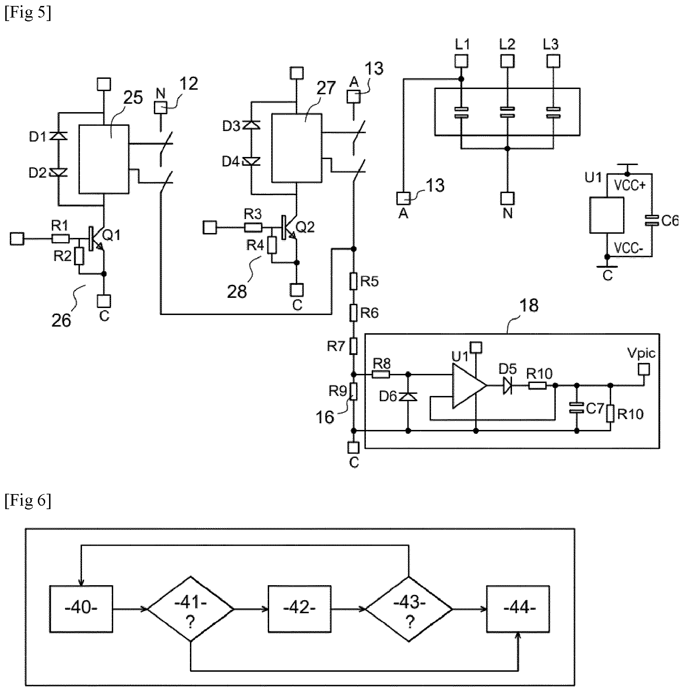

Comme on peut le voir sur la figure 6, les relais 25 et 27 peuvent être commandés pour qu'ils occupent la configuration (ii) selon une étape 40 pendant une première durée. Lors de cette étape 40, une détermination de la valeur de la tension aux bornes de la résistance de mesure 16 permet de détecter en 41 si un défaut d'isolement existe entre l'une des phases du réseau et la terre.

A la suite de cette étape 41, les relais 25 et 27 sont commandés pour qu'ils occupent la configuration (iii) selon une étape 42 pendant une deuxième durée. Cette deuxième durée peut être égale ou différente de la première durée. Ces deux durées sont par exemple égales à 1 minute. Lors de cette étape 42, une détermination de la valeur de la tension aux bornes de la résistance de mesure 16 permet de détecter en 43 si un défaut d'isolement existe entre le neutre et la terre.

La détection d'un défaut d'isolement en 41 ou 43 conduit alors à l'étape 44. Lors de cette étape, une demande d'arrêt du transfert d'énergie vers le réseau électrique peut être demandée.

La commande selon la figure 6 peut former une séquence répétée tant que le transfert d'énergie a lieu de l'unité de stockage d'énergie électrique 4 vers le connecteur 5 et tant qu'aucun défaut d'isolement n'a été détecté. Le cas échéant, entre les étapes 40 et 42, une commande des relais 35 et 37 peut être effectuée pour passer dans la configuration (i) dans laquelle les deux relais 35 et 37 sont ouverts.

La figure 5 représente un mode de réalisation plus précis du dispositif de détection 1 dont le fonctionnement a été décrit précédemment. On constate notamment que le système de détermination 18 peut mettre en oeuvre un amplificateur opérationnel de manière à récupérer la valeur de l'amplitude de la tension aux bornes de la résistance de mesure 16.

On constate aussi que trois résistances sont disposées entre le noeud et la résistance de mesure 16, au lieu de la seule résistance 29. Chacune de ces trois résistances a par exemple une valeur de quelques dizaines de k'Ω, tandis que la résistance de mesure 16 a une valeur de quelques centaines de 'Ω.

L'invention n'est pas limitée à l'exemple qui vient d'être décrit. Des réalisations de l'impédance 16 autrement que via une résistance sont par exemple possibles.

Dans une variante, le dispositif de détection 1 ne présente qu'une seule entrée. Dans une variante, la tension alternative est monophasée.

## Revendications

1. Composant électronique (2) pour la charge d'une unité de stockage d'énergie électrique (4), comprenant :
- un connecteur (5) apte à être branché à un réseau électrique fournissant une tension alternative,
- un onduleur/redresseur (6), et
- notamment un convertisseur DC/DC (8), l'onduleur/redresseur (6) étant disposé en série entre le connecteur (5) et le convertisseur DC/DC (8),
le composant (2) comprenant un dispositif de détection (1) d'un défaut d'isolement entre la terre et l'un au moins du neutre et d'une phase de la tension alternative, ce dispositif comprenant :
- une entrée (12, 13) connectée au neutre ou à une phase de la tension alternative,
- une sortie (15) connectée à la terre,
- une impédance (16), notamment une résistance de mesure (16), disposée entre l'entrée (12, 13) et la sortie (15), une détection d'un défaut d'isolement étant effectuée en fonction de la valeur d'une grandeur électrique associée à cette impédance (16),
le dispositif de détection d'un défaut d'isolement comprenant un interrupteur commandable (25, 27), configuré pour interrompre la circulation de courant entre l'entrée (12, 13) et l'impédance (16).

2. Composant selon la revendication précédente, l'interrupteur commandable (25, 27) étant un relais électrotechnique.

3. Composant selon l'une des revendications précédentes, la grandeur électrique associée à l'impédance (16) étant la tension aux bornes de cette impédance (16).

4. Composant selon la revendication 3, comprenant une unité de traitement (18, 20) configurée pour déduire de la valeur de tension mesurée aux bornes de l'impédance (16) l'une au moins de :
- la valeur de l'impédance entre le neutre et la terre et,
- la valeur de l'impédance entre la phase et la terre.

5. Composant selon l'une quelconque des revendications précédentes, l'impédance de mesure (16) étant une résistance.

6. Composant selon l'une quelconque des revendications précédentes, le dispositif de détection (1) d'un défaut d'isolement comprenant une première entrée (12) connectée au neutre de la tension alternative, et une deuxième entrée (13) connectée à une phase de la tension alternative.

7. Composant selon la revendication 6, le dispositif de détection (1) d'un défaut d'isolement définissant une première branche entre la première entrée (12) et un noeud (17), et une deuxième branche entre la deuxième entrée (13) et le noeud (17), la première branche comprenant un premier interrupteur commandable (25), notamment un premier relais électrotechnique, et la deuxième branche comprenant un deuxième interrupteur commandable (27), notamment un deuxième relais électrotechnique.

8. Composant selon la revendication 7, les premier et deuxième interrupteurs (25, 27) étant commandés de manière à ce qu'ils puissent être dans les trois configurations suivantes :
- (i) une configuration dans laquelle le premier et deuxième interrupteur sont ouverts,
- (ii) une configuration dans laquelle le premier interrupteur est fermé, et le deuxième interrupteur est ouvert, et
- (iii) une configuration dans laquelle le premier interrupteur est ouvert, et le deuxième interrupteur est fermé.

9. Composant selon la revendication 4 et la revendication 8, l'unité de traitement (18, 20) étant configurée pour :
- déduire de la valeur de tension mesurée aux bornes de l'impédance (16) un défaut d'isolement entre le neutre et la terre dans la configuration dans laquelle le premier interrupteur (25) est ouvert et le deuxième interrupteur (27) est fermé et,
- déduire de la valeur de la tension mesurée aux bornes de l'impédance (16) un défaut d'isolement entre la phase et la terre dans la configuration dans laquelle le premier interrupteur (25) est fermé, et le deuxième interrupteur (27) est ouvert.

10. Composant selon la revendication 9, la durée pendant laquelle le premier interrupteur (25) est fermé et le deuxième interrupteur (27) est ouvert étant égale à la durée pendant laquelle le premier interrupteur (25) est ouvert et le deuxième interrupteur (27) est fermé.

11. Composant selon l'une quelconque des revendications précédentes, comprenant un étage de filtrage (10) du courant alternatif, cet étage de filtrage (10) étant disposé en série entre le connecteur (5) et l'onduleur/redresseur (6), la ou les entrées (12, 13) du dispositif de détection (1) d'un défaut d'isolement étant disposées en série entre l'étage de filtrage (10) et l'onduleur/redresseur (6).

12. Composant selon l'une quelconque des revendications précédentes, comprenant un boîtier, et l'onduleur/redresseur (6) et le dispositif de détection (1) d'un défaut d'isolement entre la terre et l'un au moins du neutre et d'une phase de la tension alternative étant contenus dans ce boîtier.

13. Procédé de détection d'un défaut d'isolement entre la terre et l'un au moins du neutre et d'une phase de la tension alternative circulant dans un composant électronique (1) comprenant :
- un connecteur (5) branché à un réseau électrique ou à une charge,
- un onduleur/redresseur (6), et
- notamment un convertisseur DC/DC (8), l'onduleur/redresseur étant disposé en série entre le connecteur et le convertisseur DC/DC (8),
procédé dans lequel on utilise un dispositif de détection (1) d'un défaut d'isolement comprenant :
- une entrée (12, 13) connectée au neutre ou à une phase de la tension alternative,
- une sortie (15) connectée à la terre,
- une impédance (16), étant notamment une résistance de mesure (16) disposée entre l'entrée (12, 13) et la sortie (15), une détection d'un défaut d'isolement étant effectuée en fonction de la valeur d'une grandeur électrique associée à cette impédance (16).

14. Procédé selon la revendication 13, le dispositif de détection d'un défaut d'isolement comprenant une première entrée connectée au neutre de la tension alternative, et une deuxième entrée connectée à une phase de la tension alternative, une première branche étant définie entre la première entrée et un noeud, et cette première branche comprenant un premier interrupteur commandable, une deuxième branche étant définie entre la deuxième entrée et le noeud, et cette deuxième branche comprenant un deuxième interrupteur commandable,
procédé dans lequel :
- on commande les interrupteurs de manière à ce que le premier interrupteur soit fermé et à ce que le deuxième interrupteur soit ouvert pour détecter si un défaut d'isolement existe entre une phase et la terre, et
- on commande les interrupteurs de manière à ce que le premier interrupteur soit ouvert et à ce que le deuxième interrupteur soit fermé pour détecter si un défaut d'isolement existe entre le neutre et la terre.

15. Procédé selon la revendication 14, dans lequel on répète la séquence de commande suivante des interrupteurs :
- commande des interrupteurs de manière à ce que le premier interrupteur soit fermé et à ce que le deuxième interrupteur soit ouvert pendant une première durée, puis
- commande des interrupteurs de manière à ce que le premier interrupteur soit ouvert et à ce que le deuxième interrupteur soit fermé pendant une deuxième durée,
la première durée étant notamment égale à la deuxième durée.
